# FASCICULE DE BREVET EUROPEEN

(11) **EP 0 946 084 B1**
(45) Date de publication et mention de la délivrance du brevet: **22.12.2004**
(21) Numéro de dépôt: 99400579.1
(22) Date de dépôt: 09.03.1999
(51) Int. Cl.: H05K 7/14

(54) **Installation de raccordement électrique entre un ensemble d'appareils électriques et un système de contrôle et de commande**
Elektrische Anschlussvorrichtung zwischen elektrischen Geräten und einem Überwachungs- und Steuerungssystem
Electrical connecting device between an assembly of electrical apparatuses and a monitoring and control system

(30) Priorité: 27.03.1998 FR 9803945
(43) Date de publication de la demande: 29.09.1999
(73) Titulaire: Schneider Electric Industries SAS, 92500 Rueil-Malmaison (FR)
(72) Inventeur: Girard, Michel, 21910 Corcelles-les-Citeaux (FR); Latour, Emmanuel, 21240 Talant (FR); Sibille, Didier, 21000 Dijon (FR)

(56) Documents cités:
- EP-A- 0 518 762
- DE-A- 3 633 785
- US-A- 5 493 194

## Description

La présente invention se rapporte à une installation de raccordement électrique entre un ensemble d'appareils électriques qui sont fixés sur une embase commune et raccordés à un circuit imprimé logé dans cette embase, et un système de commande et de contrôle de cet ensemble d'appareils, l'installation comportant un dispositif d'interface électrique qui assure la connexion de signal des appareils de l'ensemble avec une liaison de signal reliée audit système.

Il est connu de regrouper des appareils électriques, comme par exemple des disjoncteurs et des contacteurs destinés à réaliser un ensemble de départ-moteur, sur une embase commune pour simplifier les opérations de montage et de câblage, et pour faciliter en outre le raccordement de l'ensemble desdits appareils au système de commande et de contrôle, tel qu'un automate programmable. L'embase loge un circuit imprimé doté de connecteurs et de pistes conductrices qui assurent l'interconnexion des appareils entre eux et la connexion externe desdits appareils avec le système de commande et de contrôle. Une partie du circuit imprimé constitue par conséquent le dispositif d'interface électrique assurant la connexion externe. Le dispositif d'interface comprend une prise de connexion usuelle multipoints lorsque la liaison de signal avec le système est un cordon d'entrées-sorties d'automate et, lorsque la liaison est un bus de terrain, il comprend une prise de connexion adaptée au type de bus ainsi qu'un élément doté d'une électronique de traitement pour la communication d'informations sur le bus.

Le dispositif d'interface électrique diffère donc selon le type de liaison de signal choisie, ce qui nécessite un circuit imprimé, et par conséquent une embase de l'ensemble des appareils, différents pour chaque choix de liaison.

L'invention a donc pour but une installation de raccordement électnque entre un ensemble d'appareils et un système de commande et de contrôle présentant un dispositif d'interface électrique dont la configuration permet de réaliser pour l'ensemble des appareils une embase unique quelque soit le type de liaison de signal choisie avec le système.

L'installation de raccordement électrique selon l'invention est caractérisée en ce que le dispositif d'interface est dissociable mécaniquement de l'embase et est assemblé à celle-ci par des moyens de fixation amovible, le dispositif étant constitué d'un boîtier qui loge un circuit imprimé sur lequel sont implantés un premier connecteur et un second connecteur qui assurent respectivement le raccordement électrique avec le circuit imprimé de l'embase portant l'ensemble des appareils et avec la liaison de signal et qui sont interconnectés par le circuit imprimé, celui-ci ainsi que le second connecteur étant spécifiquement adaptés au type de liaison de signal utilisée.

Selon une caractéristique, le dispositif d'interface comprend au moins un sélecteur monté sur le circuit imprimé du boîtier et relié, via des pistes conductrices, en amont, au premier connecteur oour assurer la connexion avec les appareils de l'ensemble et. en aval, au second connecteur pour assurer la liaison avec le système, le sélecteur réalisant la sélection d'un nombre limité d'appareils parmi ceux de l'ensemble pour les connecter au système

D'autres caractéristiques et avantages apparaîtront dans la description qui suit, en regard des dessins annexés, parmi lesquels :
- la figure 1 représente une installation de raccordement électrique selon l'invention ,
- la figure 2 illustre un ensemble d'appareils électriques couplé au dispositif d'interface de l'invention :
- la figure 3 montre le circuit imprimé du dispositif d'interface ;
- la figure 4 montre une variante du dispositif d'interface ;
- la figure 5 est un schéma électrique des connexions établies sur le circuit imprimé du dispositif d'interface

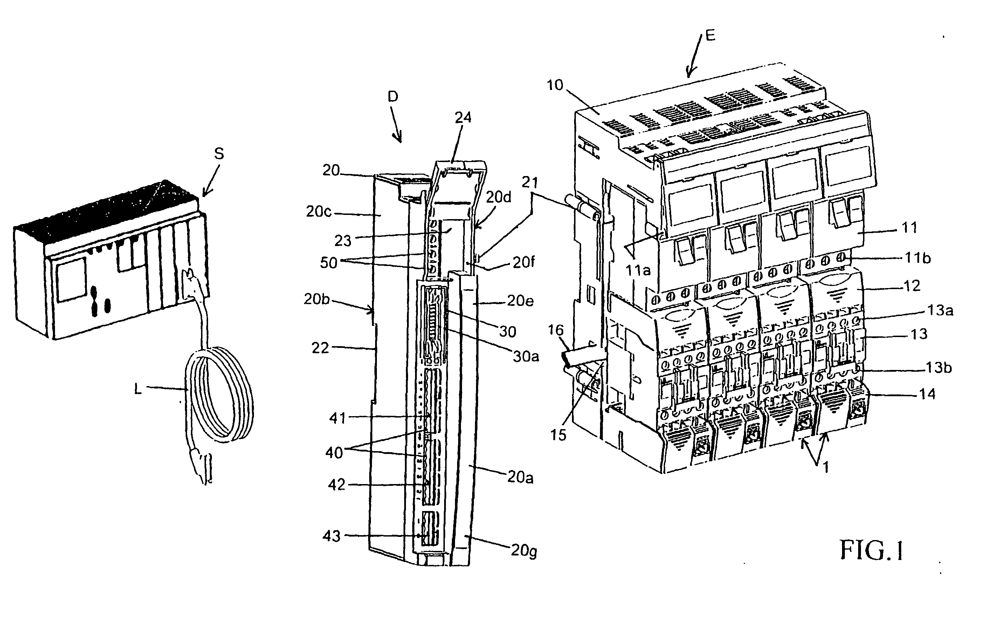

L'installation de raccordement électrique visible à la figure 1 est destinée à raccorder un ensemble E d'appareils électriques, tel qu'un ensemble de départ-moteur, à un système S de commande et de contrôle, tel qu'un automate programmable, via un dispositif d'interface électrique D dissociable mécaniquement de l'ensemble E

L'ensemble E de départ-moteur comprend des éléments de départ 1 assemblés côte à côte et fixés sur une embase commune 10. Un élément de départ 1 est constitué par un disjoncteur 11, un bloc intermédiaire 12, un contacteur 13 et un bloc inférieur 14.

Le disjoncteur 11 comprend des bornes amont 11a de puissance destinées à recevoir des éléments conducteurs reliées à des barres d'alimentation, et des bornes aval 11b devant être connectées aux bornes de puissance du contacteur. Le bloc intermédiaire 12 sert au raccordement électrique des bornes aval 11b du disjoncteur 11 à des bornes amont de puissance 13a du contacteur 13. Le contacteur 13 présente des bornes aval 13b de puissance destinées à être reliées à une charge non représentée telle qu'un moteur Enfin, le bloc inférieur 14 comprend un organe interrupteur servant à commander la bobine du contacteur, tel qu'un relais mécanique ou statique.

Les appareils électriques ci-dessus de chaque élément 1 sont connectés à un circuit imprimé non visible logé dans l'embase 10. Ce circuit imprimé assure les interconnexions entre les appareils des éléments 1 ainsi que la connexion externe de commande et de contrôle de ces derniers avec le dispositif d'interface électrique D. L'embase 10 comprend un logement latéral 15 pour accueillir un conducteur 16 de raccordement entre l'ensemble E et le dispositif d'interface D, ce conducteur étant destiné à se raccorder d'une part à un connecteur implanté sur le circuit imprimé de l'embase 10, et d'autre part à un connecteur analogue monté dans le dispositif D.

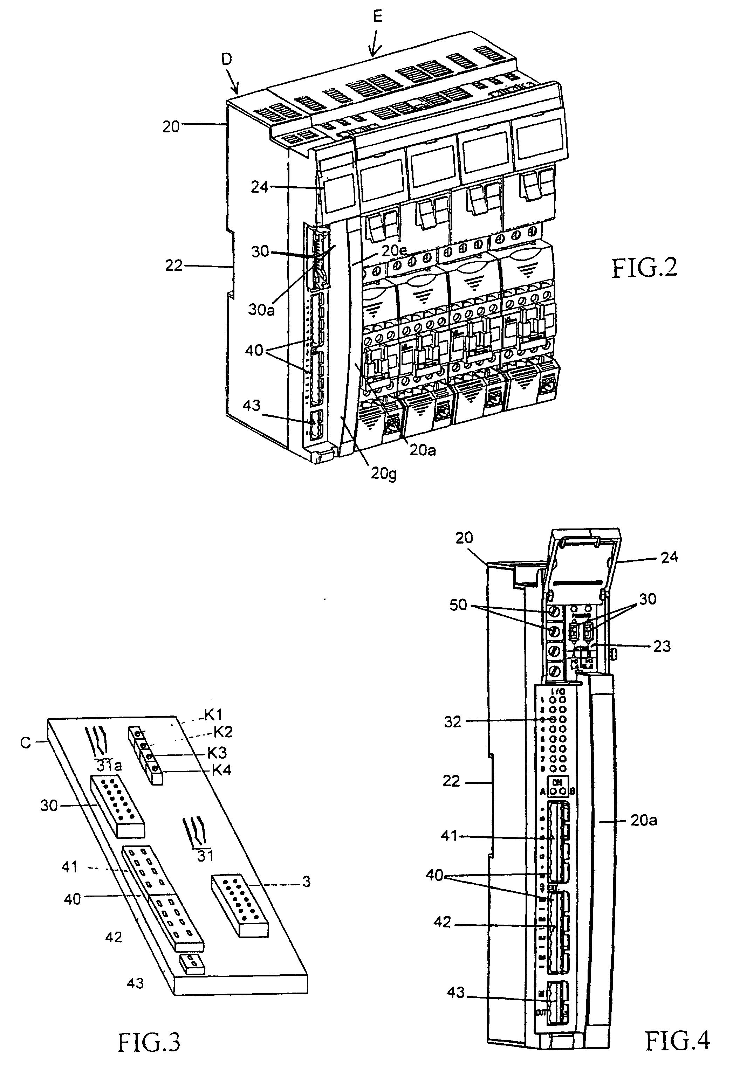

Le dispositif D d'interface électrique consiste en un boîtier 20 de forme générale parallélépipédique dont la hauteur est adaptée à celle de l'embase 10 de manière à obtenir après sa fixation mécanique à l'embase un élément monobloc de forme homogène (figure 2)

Le boîtier 20 comprend une face avant 20a, une face arrière 20b et des faces latérales 20c et 20d. L'assemblage du boîtier à l'embase 10 se fait du côté de la face latérale 20d latéralement à l'embase grâce à des moyens de fixation amovible 21. Les moyens 21 sont par exemple constitués par des tourillons solidaires de l'embase 10 et par des tenons solidaires du boîtier 20 qui sont destinés à coopérer avec lesdits tourillons. La face arrière 20b comporte un dégagement central 22 prévu pour enjamber avec un rail de support lorsque ce rail sert de moyen de support à d'autres constituants électriques.

Le boîtier 20 loge un circuit imprimé C (figure 3) sur lequel est implanté un premier connecteur 3 de raccordement du dispositif d'interface D à l'ensemble E, ce connecteur étant interne au boîtier. Une ouverture latérale non visible ménagée sur la face latérale 20d du boîtier est prévue pour accueillir le conducteur de liaison 16 devant se raccorder au connecteur 3. Le circuit imprimé C porte aussi un second connecteur 30 auquel est destiné à se raccorder une liaison L de signal qui est reliée au système S. Le connecteur 30 présente une partie de connexion 30a qui est accessible de l'extérieur du boîtier sur la face avant 20a pour le raccordement de la liaison L. Le circuit imprimé assure par des pistes conductrices 31 l'interconnexion des connecteurs 3 et 30 entre eux.

Lorsque la liaison L est un cordon d'entrées-sorties pour automate, le connecteur 30 consiste en une prise de connexion multipoints de type HE10 qui est insérée dans la partie centrale 20e de la face avant 20a du boîtier (figures 1 et 2). En variante, la prise de connexion pourrait être un bornier si la liaison L consistait en des fils de câblage.

Lorsque la liaison L est un bus de terrain, le connecteur 30 consiste en une prise de connexion qui est adaptée au type ou au protocole de bus, par exemple une prise à deux bornes pour accueillir les deux fils respectifs d'un bus AS-i (figure 4). Le connecteur 30 est installé sur la face avant, il peut par exemple être monté dans un logement 23 situé dans la partie supérieure 20f, tandis que dans la partie centrale 20e. à l'emplacement du connecteur de type HE10 de la figure 1 ou 2, sont insérées des diodes 32 qui sont aptes à clignoter de façon à renseigner sur l'état de transmission des données d'entrée-sortie sur le bus. Le connecteur 30 et les diodes 32 sont montées sur le circuit imprimé C (non illustré) de façon à être connectées à un élément doté d'une électronique de traitement implanté aussi sur le circuit (non illustré), cet élément gérant la transmission des données entre les connecteurs 3 et 30.

Par ailleurs la face avant 20a du boîtier présente dans sa partie inférieure 20g au moins un bornier 40 qui est raccordé en interne du boîtier au circuit imprimé C. Ces borniers sont destinés à relier le dispositif d'interface D à des appareils électriques individuels, non visibles sur les figures, via des fils de câblage usuels. Le dispositif D réalise le raccordement de ces appareils individuels avec le système S de commande et de contrôle par la connexion du bornier 40 au connecteur 30 via le circuit imprimé C. Les borniers 40 comportent des bornes de connexion d'entrée 41 destinées au raccordement avec des appareils du type capteurs pour recevoir des données de contrôle de ces appareils, et des bornes de connexion de sortie 42 destinées au raccordement avec des appareils du type actionneurs pour leur délivrer des ordres de commande

Enfin la partie inférieure 20g de la face avant 20a du boîtier comprend des bornes d'alimentation 43 qui sont destinées à l'alimentation externe éventuelle d'appareils électriques.

Le dispositif d'interface D de l'invention est apte à gérer la transmission de données d'entrée et de données de sortie entre le système S de contrôle et de commande et les appareils de l'embase 10 et/ou les appareils individuels.

Les données d'entrée correspondent à des renseignements sur l'état ouvert ou fermé des disjoncteurs 11 et des contacteurs 13 des éléments de départ 1 ainsi que sur l'état de fonctionnement des appareils électriques individuels constitués par des capteurs.

Les données de sortie correspondent à des ordres de commande pour ouvrir ou fermer les relais des éléments de départ 1 ainsi que pour actionner les appareils électriques individuels constitués par des actionneurs.

Le nombre d'entrées et de sorties qui sont associées au système S de contrôle et de commande via le connecteur 30 est limité, il est généralement de seize réparti en huit entrées et huit sorties. Or le nombre d'appareils électriques individuels et de l'ensemble E qui peuvent être raccordés au dispositif d'interface D peut être supérieur à seize, et il est donc préférable que l'utilisateur puisse sélectionner lesquels des appareils sont à raccorder au système S. Ainsi, le dispositif d'interface D peut comprendre des sélecteurs K1-K4 qui sont montés sur le circuit imprimé C de manière à être raccordés aux divers appareils électriques et au connecteur 30 via des pistes conductnces 31a. Ce genre de sélecteur est connu. Un sélecteur présente de manière externe à son enveloppe un moyen de réglage 50 telle qu'une tête de vis de façon à choisir la sélection désirée d'appareils parmi ceux raccordés audit sélecteur Les moyens de réglage 50 sont ici accessibles sur la face avant 20a du boîtier dans le logement 23. Le logement 23 peut être obturé par un cache amovible 24.

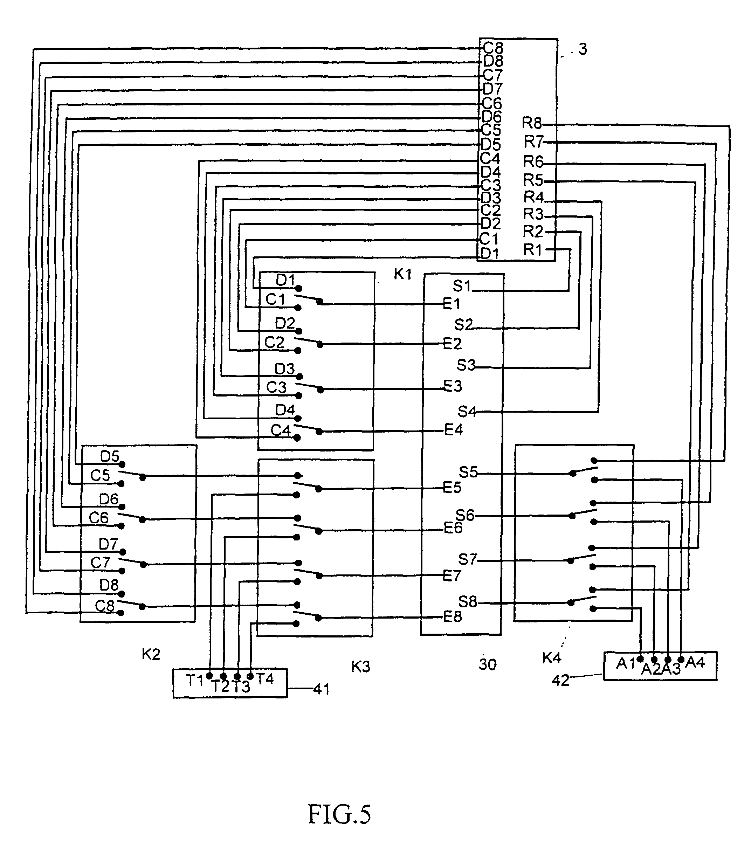

Le choix du nombre de sélecteurs. et du type de sélecteur qui est défini par le nombre de sélections, par exemple rendre un choix possible de quatre appareils électriques parmi huit, est fait lors de la fabrication du produit. Dans le mode de réalisation ci-après décrit (schéma électrique en figure 5), il est utilisé quatre sélecteurs distincts K1-K4 qui peuvent chacun permettre quatre sélections de circuits.

Un premier sélecteur K1 est connecté en amont au connecteur 3 de manière à lui raccorder quatre disjoncteurs D1-D4 et quatre contacteurs C1-C4 de l'ensemble E pour sélectionner quatre appareils parmi ces huit. Le sélecteur K1 est connecté en aval à quatre entrées E1-E4 du connecteur 30 qui correspondent aux quatre appareils sélectionnés. Un deuxième sélecteur K2 peut réaliser une sélection de quatre appareils parmi quatre autres disjoncteurs D5-D8 et quatre autres contacteurs C5-C8 de l'ensemble E. Un troisième sélecteur K3 peut réaliser. par sa connexion en amont au sélecteur K2 et aux bornes de connexion 41 du bornier 40, la sélection entre les quatre appareils choisis via le sélecteur K2 et quatre capteurs individuels T1-T4 reliés aux bornes 41 Le sélecteur K3 est raccordé en aval au connecteur 30 et réalise la sélection de quatre autres entrées E5-E8.

Enfin les huit sorties S1-S8 du connecteur 30 sont réparties en quatre sorties S1-S4 connectées à quatre relais R1-R4 de l'ensemble E et en quatre autres sorties S5-S8 qui correspondent à la sélection de quatre appareils grâce à un dernier sélecteur K4 auquel sont reliés quatre autres relais R5-R8 de l'ensemble E et/ou quatre actionneurs individuels A1-A4 raccordés aux bornes de connexion 42 du bornier 40

## Revendications

1. Installation de raccordement électrique entre un ensemble (E) d'appareils électriques qui sont fixés sur une embase commune (10) et raccordés à un circuit imprimé logé dans cette embase, et un système (S) de commande et de contrôle de cet ensemble, l'installation comportant un dispositif d'interface électrique (D) qui assure la connexion de signal des appareils de l'ensemble (E) avec une liaison de signal (L) reliée audit système (S), **caractérisée en ce que** le dispositif d'interface (D) est dissociable mécaniquement de l'embase (10) et est assemblé à celle-ci par des moyens de fixation amovible (21), le dispositif (D) étant constitué d'un boîtier (20) qui loge un circuit imprimé (C) sur lequel sont implantés un premier connecteur (3) et un second connecteur (30) qui assurent respectivement le raccordement électrique avec le circuit imprimé de l'embase (10) et avec la liaison (L) et qui sont interconnectés par le circuit imprimé (C), celui-ci ainsi que le second connecteur (30) étant spécifiquement adaptés au type de liaison (L) utilisée.

2. Installation de raccordement électrique selon la revendication 1, **caractérisée en ce que** le dispositif d'interface (D) comprend au moins un sélecteur (K1) monté sur le circuit imprimé (C) du boîtier et relié, via des pistes conductrices (31a), en amont, au premier connecteur (3) pour assurer la connexion avec les appareils de l'ensemble (E) et, en aval, au second connecteur (30) pour assurer la liaison avec le système (S), le sélecteur (K1) réalisant la sélection d'un nombre limité d'appareils parmi ceux de l'ensemble (E) pour les connecter au système (S).

3. Installation de raccordement électrique selon la revendication 1 ou 2, **caractérisée en ce que** le dispositif d'interface (D) comprend, accessible sur une face (20a) du boîtier (20) et implanté sur le circuit imprimé (C), un bornier (40) destiné à être raccordé à des appareils électriques individuels pour les relier électriquement au système (S) de contrôle et de commande.

4. Installation de raccordement électrique selon la revendication 3, **caractérisée en ce que** le dispositif d'interface (D) comprend plusieurs sélecteurs (K1-K4), au moins un premier sélecteur (K1) relié au premier connecteur (3) de liaison des appareils de l'ensemble (E) réalisant une sélection parmi lesdits appareils, un autre sélecteur (K2) relié en amont au premier sélecteur (K1) ainsi qu'au bornier (40) réalisant une sélection entre les appareils choisis grâce au premier sélecteur (K1) et des appareils individuels connectés au bornier (40).

5. Installation de raccordement électrique selon la revendication 1 ou 3, **caractérisée en ce que**, le boîtier (20) du dispositif (D) comprend sur l'une de ses faces (20a) au moins un moyen de réglage (50) qui est associé à un premier sélecteur (K1) interne au boîtier, de manière à établir une sélection donnée des appareils électriques parmi ceux connectés audit sélecteur

6. Installation de raccordement électrique selon l'une quelconque des revendications précédentes, **caractérisée en ce que** le second connecteur (30) auquel est raccordé la liaison (L) est accessible de l'extérieur du boîtier (20) sur l'une de ses faces (20a).

7. Installation de raccordement électrique selon la revendication 1, pour laquelle la liaison de signal (L) est un bus de terrain. **caractérisée en ce que** le second connecteur (30) est une prise de connexion adaptée au bus et le circuit imprimé (C) comporte un élément doté d'une électronique de traitement gérant l'échange de signaux entre le bus et le premier connecteur (3).

8. Installation de raccordement électrique selon la revendication 7, **caractérisée en ce que** le boîtier (20) du dispositif d'interface (D) comprend sur l'une de ses faces (20a) et, implantée sur le circuit imprimé (C), une série de diodes qui sont aptes à clignoter lors de la transmission de signaux sur le bus.

9. Installation de raccordement électnque selon la revendication 1, pour laquelle la liaison de signal (L) est un cordon d'automate, **caractérisée en ce que** le second connecteur (30) est une prise de connexion multipoints.

## Patentansprüche

1. Vorrichtung für den elektrischen Anschluss zwischen einer Gruppe (E) von elektrischen Geräten, die auf einem gemeinsamen Sockel (10) befestigt und an eine in diesem Sockel befindliche gedruckte Schaltung angeschlossen sind, und einem System (S) zur Steuerung und Kontrolle dieser Gruppe, wobei die Vorrichtung eine elektrische Schnittstelleneinrichtung (D) umfasst, die den Signalanschluss der Geräte der Gruppe (E) mit einer Signalverbindung (L), die an das System (S) angeschlossen ist, sicherstellt, **dadurch gekennzeichnet, dass** die Schnittstelleneinrichtung (D) mechanisch von dem Sockel (10) trennbar und an diesem durch abnehmbare Befestigungsmittel (21) befestigt ist, wobei die Einrichtung (D) von einem Gehäuse (20) gebildet ist, das eine gedruckte Schaltung (C) beherbergt, auf der ein erster Stecker (3) und ein zweiter Stecker (30) vorgesehen sind, die den elektrischen Anschluss mit der gedruckten Schaltung des Sockels (10) bzw. der Verbindung (L) sicherstellen und durch die gedruckte Schaltung (C) zusammengeschlossen sind, wobei diese sowie der zweite Stecker (30) spezifisch an den verwendeten Verbindungstyp (L) angepasst sind.

2. Elektrische Anschlussvorrichtung nach Anspruch 1, **dadurch gekennzeichnet, dass** die Schnittstelleneinrichtung (D) mindestens einen Auswahlschalter (K1) umfasst, der auf der gedruckten Schaltung (C) des Gehäuses befestigt und über Leiterspuren (31a) stromaufwärts mit dem ersten Stecker (3) verbunden ist, um den Anschluss an die Geräte der Gruppe (E) sicherzustellen, und stromabwärts mit dem zweiten Stecker (30) verbunden ist, um die Verbindung mit dem System (S) sicherzustellen, wobei der Auswahlschalter (K1) die Auswahl einer begrenzten Anzahl von Geräten unter jenen der Gruppe (E) vornimmt, um sie an das System (S) anzuschließen.

3. Elektrische Anschlussvorrichtung nach Anspruch 1 oder 2, **dadurch gekennzeichnet, dass** die Schnittstelleneinrichtung (D) auf einer Seite (20a) des Gehäuses (20) zugänglich und auf der gedruckten Schaltung (C) angeordnet eine Klemmenleiste (40) umfasst, die dazu bestimmt ist, an elektrische Einzelgeräte angeschlossen zu werden, um sie elektrisch an das System (S) zur Kontrolle und Steuerung anzuschließen.

4. Elektrische Anschlussvorrichtung nach Anspruch 3, **dadurch gekennzeichnet, dass** die Schnittstelleneinrichtung (D) mehrere Auswahlschalter (K1-K4) umfasst, mindestens einen ersten Auswahlschalter (K1), der mit dem ersten Verbindungsstecker (3) der Geräte der Gruppe (E) verbunden ist und eine Auswahl unter diesen Geräten vornimmt, einen weiteren Auswahlschalter (K2), der stromaufwärts mit dem ersten Auswahlschalter (K1) sowie mit der Klemmenleiste (40) verbunden ist und eine Auswahl zwischen den Geräten, die mit dem ersten Auswahlschalter (K1) ausgewählt wurden, und Einzelgeräten vornimmt, die an die Klemmenleiste (40) angeschlossen sind.

5. Elektrische Anschlussvorrichtung nach Anspruch 1 oder 3, **dadurch gekennzeichnet, dass** das Gehäuse (20) der Vorrichtung (D) auf einer seiner Seiten (20a) mindestens ein Einstellmittel (50) umfasst, das mit einem ersten Auswahlschalter (K1) im Inneren des Gehäuses verbunden ist, um eine gegebene Auswahl der elektrischen Geräte unter den an den Auswahlschalter angeschlossenen vorzunehmen.

6. Elektrische Anschlussvorrichtung nach einem der vorhergehenden Ansprüche, **dadurch gekennzeichnet, dass** der zweite Stecker (30), an den die Verbindung (L) angeschlossen ist, von außerhalb des Gehäuses (20) auf einer seiner Seiten (20a) zugänglich ist.

7. Elektrische Anschlussvorrichtung nach Anspruch 1, bei der die Signalverbindung (L) ein Erdbus ist, **dadurch gekennzeichnet, dass** der zweite Stecker (30) ein Anschluss ist, der an den Bus angepasst ist, und dass die gedruckte Schaltung (C) ein Element umfasst, das mit einer Bearbeitungselektronik versehen ist, die den Signalaustausch zwischen dem Bus und dem ersten Stecker (3) steuert.

8. Elektrische Anschlussvorrichtung nach Anspruch 7, **dadurch gekennzeichnet, dass** das Gehäuse (20) der Schnittstelleneinrichtung (D) auf einer seiner Seiten (20a) und auf der gedruckten Schaltung (C) angeordnet eine Reihe von Dioden umfasst, die bei der Signalübertragung auf den Bus blinken können.

9. Elektrische Anschlussvorrichtung nach Anspruch 1, bei der die Signalverbindung (L) ein Automatenkabel ist, **dadurch gekennzeichnet, dass** der zweite Stecker (30) ein Mehrpunktanschluss ist.

## Claims

1. An installation for the electrical connection between an assembly (E) of items of electrical equipment which are fixed onto a common baseplate (10) and a system (S) for command and control of that assembly, the installation comprising an electrical interface device (D) which provides the connection of the signal from the equipment in the assembly to a signal linkage (L) connected to said system (S), **characterised in that** the interface device (D) can be mechanically dissociated from the baseplate (10) and is attached to it by detachable fixing means (21), the device (D) being made up of a casing (20) which houses a printed circuit (C) on which a first connector (3) and a second connector (30) are located which respectively provide the electrical connection with the printed circuit of the baseplate (10) and with the linkage (L) and which are interconnected through the printed circuit (C), this and the second connector (30) being specifically adapted to the type of linkage (L) used.

2. An electrical connection installation according to Claim 1 **characterised in that** the interface device (D) comprises at least one selector switch (K1) mounted on the printed circuit (C) of the casing and connected, through conductive tracks (31a), upstream to the first connector (3) to provide the connection with the equipment making up the assembly (E) and, downstream, to the second connector (30) to provide the linkage with the system (S), the selector switch (K1) making the selection of a limited number of items of equipment from among those in the assembly (E) in order to connect them to the system (S).

3. An electrical connection installation according to Claim 1 or 2 **characterised in that** the interface device (D) comprises, accessible on a face (20a) of the casing (20) and located on the printed circuit (C), a terminal block (40) intended to be connected to individual items of electrical equipment in order to connect them electrically to the control and command system (S).

4. An electrical connection installation according to Claim 3 **characterised in that** the interface device (D) comprises several selector switches (K1-K4), at least one first selector switch (K1) connected to the first connector (3) for linkage of the equipment in the assembly (E) making a selection from among said items of equipment, another selector (K2), connected upstream of the first selector (K1) and the terminal block (40), that makes a selection between the pieces of equipment chosen by the first selector (K1) and individual items of equipment connected to the terminal block (40).

5. An electrical connection installation according to Claim 1 or 3 **characterised in that** the casing of the device (D) comprises on one of its faces (20a) at least one adjustment means (50) which is linked to a first selector switch (K1) inside the casing, in a manner that establishes a given selection of items of electrical equipment from among those connected to said selector switch,

6. An electrical connection installation according to any one of the preceding Claims **characterised in that** the second connector (30) to which the linkage (L) is connected, is accessible from the outside of the casing (20) on one of its faces (20a).

7. An electrical connection installation according to Claim 1, for which the signal linkage (L) is an area bus, **characterised in that** the second connector (30) is a connection plug adapted to the bus and the printed circuit (C) includes an element fitted with an electronic processing unit that manages the exchange of signals between the bus and the first connector (3).

8. An electrical connection installation according to Claim 7, **characterised in that** the casing (20) of the interface device (D) comprises on one of its faces (20a) and, located on the printed circuit (C), a series of diodes which are capable of flashing during the transmission of signals on the bus.

9. An electrical connection installation according to Claim 1, for which the signal linkage (L) is a controller lead, **characterised in that** the second connector (30) is a multi-point connection plug.
